# EUROPEAN PATENT SPECIFICATION

(11) **EP 4 394 405 B1**
(45) Date of publication and mention of the grant of the patent: **01.07.2026**
(21) Application number: 23214680.3
(22) Date of filing: 06.12.2023
(51) Int. Cl.: G01R 31/374, G01R 31/389, G01R 31/392, G01R 31/385

(54) **SECONDARY BATTERY ACCELERATED IDLE LIFE EVALUATION DEVICE AND METHOD THEREOF**
VORRICHTUNG ZUR BESCHLEUNIGTEN LEERLAUFLEBENSDAUERBEWERTUNG EINER SEKUNDÄRBATTERIE UND VERFAHREN DAFÜR
DISPOSITIF D'ÉVALUATION DE DURÉE DE VIE EN VEILLE ACCÉLÉRÉE DE BATTERIE SECONDAIRE ET PROCÉDÉ ASSOCIÉ

(30) Priority: 27.12.2022 KR 20220185657
(43) Date of publication of application: 03.07.2024
(73) Proprietor: Samsung SDI Co., Ltd., Yongin-si, Gyeonggi-do 17084 (KR)
(72) Inventor: KIM, Yong Chan, 17084 Yongin-si (KR); YOON, Seon Hye, 17084 Yongin-si (KR); KIM, Hye Won, 17084 Yongin-si (KR); PARK, Su Jin, 17084 Yongin-si (KR); OH, Jeong Won, 17084 Yongin-si (KR)
(74) Representative: Walaski, Jan Filip

(56) References cited:
- WO-A1-2018/106930
- CN-A- 104 991 195
- KR-B1- 102 194 845
- US-A1- 2021 135 304
- US-A1- 2022 077 491

## Description

### CROSS-REFERENCE TO RELATED APPLICATION

Priority is claimed to Korean Patent Application No. 10-2022-0185657 filed on December 27, 2022, in the Korean Intellectual Property Office.

### BACKGROUND

### 1. Field

Embodiments relate to a device and method for evaluating an accelerated idle life of a secondary battery.

### 2. Description of the Related Art

Lithium-ion secondary batteries have grown mainly in small-sized batteries that are used in IT devices such as mobile phones and laptops, but recently, it is desirable to require long life, high output, and safety due to the characteristics in large-capacity application fields while the demand for large-capacity secondary batteries is increasing as its use is expanding for medium/large-sized power storage such as electric vehicles and ESS.

CN104991195A discloses a high-temperature accelerated storage test method for zinc-silver battery.

### SUMMARY

The present invention provides a method as defined in claim 1, and a device as defined in claim 8. Optional features are set out in the dependent claims.

### BRIEF DESCRIPTION OF THE DRAWINGS

Features will become apparent to those of skill in the art by describing in detail exemplary embodiments with reference to the attached drawings in which:
FIG. 1 shows a block diagram of a device including an input unit, a data processing unit, a storage unit, and a display unit, for evaluating an accelerated idle life of a secondary battery according to example embodiments.
FIG. 2 shows a method for evaluating an accelerated idle life according to example embodiments.
FIG. 3 shows a table including multiple life evaluation periods for multiple secondary batteries under idle evaluation conditions.
FIG. 4A shows a graph of a remaining life depending on the evaluation period of each secondary battery of FIG. 3.
FIG. 4B shows a direct current internal resistance increase rate depending on the evaluation period of each secondary battery of FIG. 3.
FIG. 4C shows a graph of direct current internal resistance depending on a state of health of each secondary battery of FIG. 3.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

In addition, in the following drawings, the thickness or size of each layer is exaggerated for convenience and clarity of description, and the same reference numerals in the drawings refer to the same elements. As used herein, the term "and/or" includes any and all combinations of one or more of the associated listed items. In this specification, it will also be understood that when a member A is referred to as being connected to a member B, the member A can be directly connected to the member B or indirectly connected to the member B with a member B therebetween.

The terms used in this specification are for illustrative purposes of the present disclosure only and should not be construed to limit the meaning or the scope of the present disclosure. As used in this specification, a singular form may, unless definitely indicating a particular case in terms of the context, include a plural form. Also, the expressions "comprise" and/or "comprising" used in this specification neither define the mentioned shapes, numbers, processes, operations, members, elements, and/or groups of these, nor exclude the presence or addition of one or more other different shapes, numbers, processes, operations, members, elements, and/or groups of these, or addition of these. The term "and/or" used herein includes any and all combinations of one or more of the associated listed items.

As used herein, terms such as "first," "second," etc. are used to describe various members, components, areas, layers, and/or portions. However, it is obvious that the members, components, areas, layers, and/or portions should not be defined by these terms. The terms do not mean a particular order, up and down, or superiority, and are used only for distinguishing one member, component, area, layer, or portion from another member, component, area, layer, or portion. Thus, a first member, component, area, layer, or portion which will be described may also refer to a second member, component, area, layer, or portion, without departing from the teaching of the present disclosure.

Spatially relative terms, such as "below", "beneath", "lower", "above", "upper" and the like, used herein for ease of description to describe one element or feature's relationship to another element(s) or feature(s) as illustrated in the figures. These spatially relative terms are intended for easy comprehension of the prevent invention according to various process states or usage states of the prevent invention, and thus, the present disclosure is not limited thereto. For example, if an element or feature shown in the drawings is turned inside out, the element or feature described as "beneath" or "below" may change into "above" or "upper". Thus, the term "below" may encompass the term "above" or "below".

Preferred embodiments of the present disclosure will be described in detail with reference to the accompanying drawings so that those skilled in the art can easily implement the present disclosure.

Here, throughout the specification, parts having similar configurations and operations are denoted by the same reference numerals. Also, in this specification below, when any portion is referred to as being "electrically connected" to another portion, it should be understood that the former can be "directly connected" to the latter, or "connected" to the latter via an intervening member.

In addition, a device for evaluating an accelerated idle life and/or other related devices or components according to the present disclosure may be implemented using any suitable hardware, firmware (e.g., application-specific semiconductor), software, or a suitable combination of software, firmware, and hardware. For example, various components of a device for evaluating an accelerated idle life and/or other related devices or parts according to the present disclosure may be formed on one integrated circuit chip or a separate integrated circuit chip. In some embodiments, various components of the device for evaluating the accelerated idle life may be implemented on a flexible printed circuit film and may be formed on a tape carrier package, a printed circuit board, or a substrate that is the same as the device for evaluating a life. In some embodiments, various components of the device for evaluating the accelerated idle life may be processors or threads, which are executed in one or more processors, in one or more computing devices, and it may execute computer program instructions and interact with other components to perform various functions discussed below. The computer program instructions may be stored in memory that is capable of being executed in the computing device using standard memory device such as, for example, random access memory. The computer program instructions may also be stored in other non-transitory computer readable media such as, for example, a CD-ROM, flash drive or the like. In some embodiments, those skilled in the art related to the present disclosure should be recognized that the functions of various computing devices are combined with each other or incorporated into one computing device, or the functions of a particular computing device are dispersed in one or more other computing devices without departing from the exemplary embodiments of the present disclosure.

For example, the device for evaluating the accelerated idle life according to the present disclosure may operate on a normal commercial computer constituted by a central processing unit, a mass storage device such as a hard disk or a solid-state disk, a volatile memory device, an input device such as a keyboard or a mouse, and an output device such as a monitor or a printer.

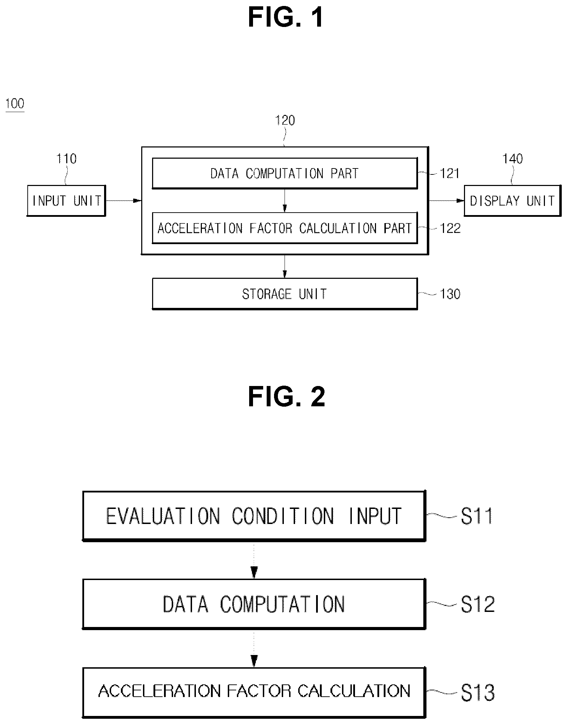

FIG. 1 illustrates a block diagram of a device for evaluating an accelerated idle life for life tests of the secondary battery according to embodiments.

First, a secondary battery manufactured according to various and complicated design factors may be evaluated for life according to a method for evaluating an accelerated idle life according to the present disclosure. In some embodiments, the method for evaluating the accelerated idle life may mean a method for measuring an evaluation period to reach a limit SOH (state of health) by degrading the secondary battery under accelerated idle evaluation conditions to determine whether shipment is possible.

General examples of the method for evaluating the accelerated idle life of the secondary battery such as a lithium ion battery are as follows.

In some implementations, after the secondary battery is charged with constant current at about 0.2 C to about 0.4 C (Coulombs) (preferably, about 0.3 C) under a temperature condition of about 20°C to about 30°C (degrees Celsius) (preferably, about 25°C), if a cell voltage of about 4.2 V, which is an upper limit voltage, is reached, constant voltage charging may proceed, and if a current limit value of about 0.001 C to about 0.02 C (preferably, about 0.01 C) is reached, the charging may be stopped. In some embodiments, the secondary battery may be charged in a constant current-constant voltage manner, and if an SOC becomes about 100%, the charging may be stopped. Thereafter, the secondary battery having the SOC of 100% may be idled for a long period of time in a chamber having a temperature of about 50°C to about 80°C (preferably, about 60°C) as described above. In some implementations, if the fully charged secondary battery is idled in the chamber at a temperature of about 20°C to about 30°C for a long period of time, it may be regarded as a normal idle condition, and if the secondary battery is idled in the chamber having a temperature of about 50°C to about 80°C for a long period of time, it may be regarded as an accelerated idle condition.

In some embodiments, a reference performance test (RPT) may be performed for every measurement period of about 10 days to about 40 days to check a change in electrical behavior of the secondary battery and polarization characteristics of the battery.

In some embodiments, the RPT may be performed in a constant current-constant voltage charging method and a constant current discharging method similar to the above. In an implementation, after the secondary battery is charged with constant current at about 0.01 C to about 0.5 C (preferably, about 0.05 C) under a temperature condition of about 20°C to about 30°C (preferably, about 25°C), if a cell voltage of about 4.2 V, which is an upper limit voltage, is reached, constant voltage charging may proceed, and then, if a current limit value of about 0.001 C to about 0.02 C (preferably, about 0.01 C) is reached, the charging may be stopped. Thereafter, the secondary battery may be discharged in the constant current manner until reaching a cell voltage of about 3V, which is a lower limit voltage. In an implementation, the discharging process may be performed at various C-rates such as about 0.05 C, about 0.125 C, about 0.25 C, and about 0.5 C.

In general, because a typical method for evaluating an idle life, in which an idle temperature is low, and an RPT measurement cycle is long, requires a long time in proportion to the life of the product (secondary battery), it may be difficult to obtain results in a short time.

In some embodiments, in the method for evaluating the accelerated idle life according to the present disclosure, both the temperature and the RPT measurement cycle, which may be set in the typical method for evaluating the idle life, may be changed to reduce the accelerated idle life evaluation period compared to the typical accelerated idle life evaluation period.

Referring to FIG. 1, an exemplary device 100 for evaluating an accelerated idle life according to embodiments of the present disclosure may include an input unit 110, a data processing unit 120, a storage unit 130, and a display unit 140. In some embodiments, the device 100 for evaluating the accelerated idle life may be implemented by a personal computer or a server computer. As used herein, the term "or" is not an exclusive term, e.g., "A or B" would include A, B, or A and B.

Evaluation conditions for evaluating the accelerated idle life of the secondary battery may be input into the input unit 110. In an implementation, data such as the idle temperature for evaluating the accelerated idle life and an RPT measurement interval may be input into the input unit 110. Such the data may be automatically input from an experiment, measurement or evaluation device or may be manually input by a keyboard or a mouse.

The data processing unit 120 may include a data computation part 121 and an acceleration factor calculation part 122. In some embodiments, the data processing unit 120 may be implemented by program, or software, which may be installed in a computer.

The data computation part 121 may compute a capacity degradation rate, a DC-IR change rate, and an evaluation period of the secondary battery.

The acceleration factor calculation part 122 may calculate an acceleration factor (A.F) according to the capacity degradation rate and the DC-IR change rate, which are calculated by the data computation part 121.

The storage unit 130 may store various data of the input unit 110 and the data processing unit 120. In some embodiments, the storage unit 130 may store not only evaluation conditions input into the input unit 110, but also the capacity degradation rate, the DC-IR change rate, the evaluation period, and the acceleration factor. The storage unit 130 may be a normal hard disk, flash memory, CD ROM.

The display unit 140 may display various data of the input unit 110 and the data processing unit 120. In some embodiments, the display unit 140 may display not only the evaluation conditions input into the input unit 110, but also the capacity degradation rate, the DC-IR change rate, and the acceleration factor. This display unit 140 may be a normal LCD monitor.

An operation of the device 100 for evaluating the accelerated idle life will be described in more detail through a method for evaluating the accelerated idle life, which will be described below.

In general, a degradation mechanism of the lithium ion secondary battery may be explained by a cyclic effect and a storage effect. The cycle effect may mean a phenomenon in which impurities and oxygen may be generated if lithium ions are intercalated into and deintercalated from a positive electrode plate and a negative electrode plate by repetitive charging and discharging of the battery, and as a result, impurities may be precipitated on a separator, or the DC-IR of the lithium ion secondary battery increases due to an oxygen gas. In some embodiments, the storage effect may mean a phenomenon in which a film is formed by reduction decomposition of the negative electrode plate in the process of idling the battery for a long time, and the reduced material may be migrated to the positive electrode plate and adsorbed to the positive electrode plate to increase in electrical resistance. In the present disclosure, the life of the battery may be evaluated using the phenomenon in which the DC-IR increases due to a storage effect rather than a cyclic effect.

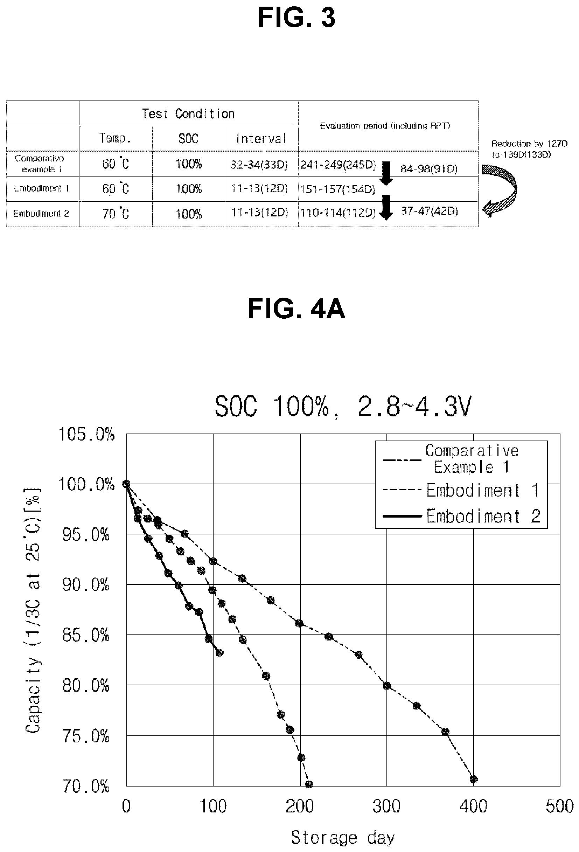

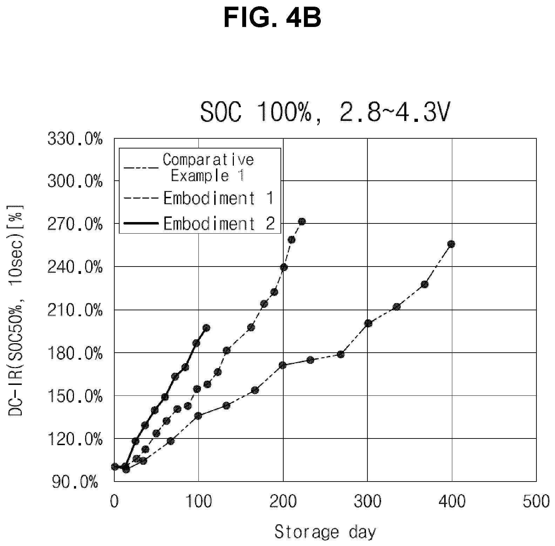

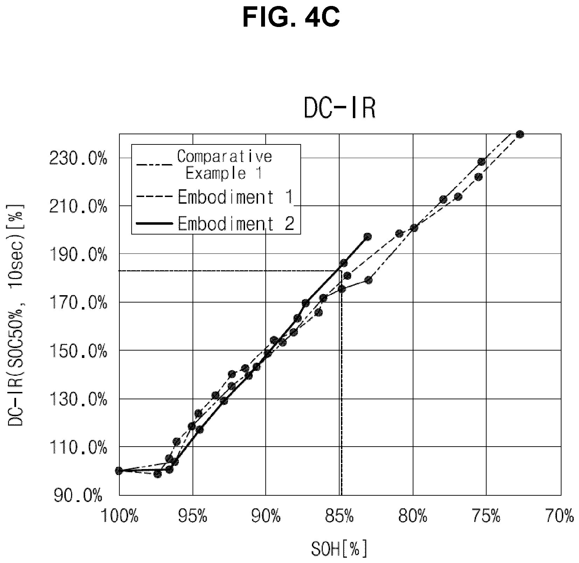

FIG. 2 illustrates a flowchart of a method for evaluating an accelerated idle life according to embodiments. FIG. 3 illustrates a table of a life evaluation period of each secondary battery under idle evaluation conditions. FIG. 4A illustrates a graph of a remaining life depending on the evaluation period of each secondary battery of FIG. 3. In some embodiments, an X-axis (horizontal axis) may be an evaluation time (day) of the secondary battery, and a Y-axis (vertical axis) may be a remaining life (capacity (%) or SOH) of the secondary battery. In an implementation, the remaining life may be a value measured after charging the secondary battery to about 1/3 C at about 25°C. FIG. 4B illustrates a DC-IR increase rate depending on the evaluation period of each secondary battery of FIG. 3. In some embodiments, an X-axis (horizontal axis) may be an evaluation time (day) of the secondary battery, and a Y-axis (vertical axis) may be DC-IR (%) of the secondary battery. In an implementation, the DC-IR may be a value measured for about 10 seconds when the SOC is about 50%. FIG. 4C illustrates a graph of direct current internal resistance (DC-IR) depending on the SOH of each secondary battery of FIG. 3. In some embodiments, an X-axis (horizontal axis) may be SOH (%) of the secondary battery, and a Y-axis (vertical axis) may be DC-IR (%) of the secondary battery.

Referring to FIG. 2, a method for evaluating an accelerated idle life according to the present disclosure may include an evaluation condition input process (S11), a data computation process (S12), and an acceleration factor calculation process (S13).

In the evaluation condition input process (S11), a temperature and an RPT measurement cycle for evaluating the accelerated idle life may be input. As illustrated in FIG. 3, Comparative Example 1, and Embodiments 1 and 2 were prepared so as to confirm that the evaluation period is reduced through the method for evaluating the accelerated life according to the present disclosure. The secondary battery according to Comparative Example 1 was set under the conditions depending on the typical method for evaluating the idle life, and in the secondary batteries according to Embodiments 1 and 2, the idle temperature and/or the RPT measurement period were set to be changed depending on the method for evaluating the accelerated idle life according to the present disclosure.

In Comparative Example 1, a state of charge (SOC of the secondary battery was set at about 100%, an idle temperature was set at about 60°C, and an RPT measurement period was set to about 32 days to about 34 days (preferably, about 33 days (33D)). Embodiment 1 was set under the same condition as Comparative Example 1, except that the RPT measurement period according to Comparative Example 1 is changed from about 33 days to about 11 to about 13 days (preferably, about 12 days (12D)). Embodiment 2 was set under the same condition as Comparative Example 1, except that, in Comparative Example 1, the idle temperature may be changed from about 60°C to about 70°C, and the RPT measurement period may be changed from about 33 days to about 11 to about 13 days (preferably, about 12 days. In the evaluation condition input process (S11), the evaluation conditions (temperature and RPT measurement period) according to Comparative Example 1, Embodiment 1, and Embodiment 2 may be input through the input unit 110.

In the data computation process (S12), the evaluation period until the state of health (SOH) of each secondary battery reaches about 85% may be measured in a state in which the evaluation conditions may be set as described above. Referring to FIGS. 3 and 4A, the evaluation period in which the SOH of the secondary battery according to Comparative Example 1 reaches about 85% was about 241 days to about 249 days (e.g., about 245 days (about 8.2 months)), but the evaluation period in which the SOH of the secondary battery according to Embodiment 1 reaches about 85% was about 151 days to about 157 days (e.g., about 154 days (about 5.1 months)), and the evaluation period in which the SOH of the secondary battery according to Embodiment 2 reaches about 85% was about 110 days to about 114 days (e.g., about 112 days (about 3.7 months)).

It was confirmed that, if only the RPT measurement period is changed as in Embodiment 1, the evaluation period may be reduced by about 84 days to about 98 days (e.g., about 91 days (about 3 months) (about 37%)) compared to Comparative Example 1, and if the RPT measurement period and temperature are changed together as in Embodiment 2, the evaluation period may be reduced by about 127 days to about 139 days (e.g., about 133 days (about 4.4 months) (about 53%)) compared to Comparative Example 1.

In an embodiment, in the method for evaluating the accelerated idled life according to the present disclosure, the accelerated idled life evaluation period may be reduced by changing both the RPT measurement period and the idle temperature. In some implementations, the evaluation period of about 8 months was required to measure the remaining life (SOH) under conditions required by a customer (e.g., a company that manufactures electronic products equipped with a secondary battery). As described above, this may be a fatal weakness in information communication products having a very short development cycle. In order to overcome this limitation, in the present disclosure, the device and method for evaluating the accelerated idle life under the accelerated idle condition have been developed. As described above, if the method for evaluating the accelerated idle life according to the present disclosure is used, the evaluation period may be reduced from about 8 months to about 4 months.

In Comparative Example 1, the evaluation may be performed by changing only the idle temperature, but in some embodiments, it may be difficult to acquire meaningful data because a vent of the secondary battery is opened. In some embodiments, if the idle temperature is set to about 70°C or more, because an amount of gas generated from the secondary battery increases rapidly due to side reactions, a case in which an internal pressure of the secondary battery becomes higher than a rupture pressure of the vent (safety vent) before the degradation of the secondary battery to open the vent may occur.

In some embodiments, referring to FIG. 4B, the DC-IR increase rate of each of the secondary batteries according to Embodiments 1 and 2 may increase rapidly compared to the DC-IR increase rate of the secondary battery according to Comparative Example 1. In some embodiments, it may be seen that, in the method for evaluating the accelerated idle life, which is performed to predict the life of the secondary battery, the harsher the evaluation condition, the higher the DC-IR increase rate to the evaluation period.

In some embodiments, as illustrated in FIG. 4C, a graph showing correlation between the SOH and the DC-IR was obtained. In Comparative Example 1 and Embodiments 1 and 2, it was seen that a ratio (inclination) of the DC-IR increase rate to the SOH of the secondary battery may be substantially constant, even though the conditions for evaluating the life of the battery (or degradation conditions) may be different. In some embodiments, in the art, it is recognized as a highly reliable acceleration evaluation method if an inclination angle of a straight line drawn between the X axis and the Y axis in FIG. 4C is about 40° to 70°. In some embodiments, it may be seen that the method for evaluating the accelerated idle life according to the present disclosure has excellent reliability.

In the acceleration factor calculation process (S13), an acceleration factor (A.F) may be calculated by the following equation. In an implementation, the acceleration factor calculation part 122 may calculate the acceleration factor using the following equation.

Acceleration factor (A.F) = DC-IR increase rate (%)/Capacity degradation rate (%)

In some embodiments, as illustrated in FIG. 4C, if the SOH of the secondary battery according to Embodiment 2 is changed from about 100% to about 85%, the DC-IR may be changed from about 100% to about 185%. In some embodiments, the capacity degradation rate of the secondary battery according to Embodiment 2 may be about 15%, the DC-IR increase rate may be about 85%, and the acceleration factor of the secondary battery according to Embodiment 2 may be about 5.67 (A.F = 85/15=5.67).

Based on these results, in the method for evaluating the accelerated idle life according to the present disclosure, the acceleration factor (A.F) may satisfy the following range. (4 < A.F < 7).

In some embodiment, if the acceleration factor (A.F) satisfies the above range, it may be determined that the reliability of the method for evaluating the accelerated idle life according to the present disclosure is within a reference range. In an implementation, if the acceleration factor is less than about 4 or greater than about 7, this may mean that the inclination angle of the straight line drawn between the capacity degradation rate (%) and the DC-IR increase rate (%) in FIG. 4C is out of about 40° to about 70°, and thus, the reliability of the method for evaluating the accelerated idle life is low. As described above, if the reliability of the method for evaluating the accelerated idle life is low, the life evaluation result of the secondary battery evaluated according to the present disclosure may be distrusted in the market.

In some embodiments, the acceleration factor (A.F) in the method for evaluating the accelerated idle life according to the present disclosure may be about 5 to about 6, and in this case, the reliability of the method for evaluating the accelerated life may be considered the best. In some embodiments, if the acceleration factor is about 5 to about 6, the reliability of the accelerated idle life evaluation result according to the present disclosure may be highly evaluated in the market.

In the method for evaluating the accelerated idle life according to the embodiments of the present disclosure, the temperature and the measurement period of the preference performance test (RPT) may be set together to reduce the evaluation period of the accelerated idle life.

By way of summation and review, performance and life tests are essential for performance evaluation, improvement, and development of new products for market entry, but the life tests of the secondary batteries require a long time in proportion to the product life, making it difficult to obtain results in short time.

According to some embodiments, a device for evaluating an accelerated idle life of a secondary battery may include an input unit configured to receive an idle temperature and a measurement period for a reference performance test (RPT) to evaluate the accelerated idle life of the secondary battery, a data computation unit configured to compute an evaluation period, in which a state of health (SOH) of the secondary battery reaches a predetermined range, a capacity degradation rate, and a direct current internal resistance (DC-IR) change rate, and an acceleration factor calculation unit configured to calculate an acceleration factor (A.F) of the secondary battery using the following equation: acceleration factor (A.F) = DC-IR increase rate (%)/Capacity degradation rate (%).

The above-described information disclosed in the technology that serves as the background of the present disclosure is only for improving understanding of the background of the present disclosure and thus may include information that does not constitute the related art.

By way of summation and review, aspects of some embodiments of the present disclosure provide a device and method for evaluating an accelerated idle life of a secondary battery, which are capable of reducing an evaluation period for a life test of the secondary battery.

Example embodiments have been disclosed herein, and although specific terms are employed, they are used and are to be interpreted in a generic and descriptive sense only and not for the purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A method for evaluating an accelerated idle life of a secondary battery, comprising:
an evaluation condition input process (S11) including inputting an idle temperature and a measurement period for a reference performance test to evaluate the accelerated idle life of the secondary battery;
a data computation process (S12) including computing an evaluation period, in which a state of health of the secondary battery reaches a set range, a capacity degradation rate, and a direct current internal resistance change rate; and
an acceleration factor calculation process (S13) including calculating an acceleration factor of the secondary battery using a first equation that the acceleration factor is equal to the direct current internal resistance change rate divided by a capacity degradation rate.

2. The method as claimed in claim 1, wherein, after the secondary battery is idled while a state of charge is about 100% at a first temperature, the reference performance test is performed at a second temperature less than the first temperature for every measurement period.

3. The method as claimed in claim 2, wherein the first temperature is about 50°C to about 80°C, the second temperature is about 20°C to about 30°C, and the measurement period is about 10 days to about 40 days.

4. The method as claimed in claim 1, wherein the reference performance test is performed by charging the secondary battery in a constant current-constant voltage manner and discharging the secondary battery in a constant current manner.

5. The method as claimed in any one of the preceding claims, wherein the set range of the state of health of the secondary battery is about 80% to about 90%.

6. The method as claimed in any one of the preceding claims, wherein the acceleration factor is about 4 to about 7.

7. The method as claimed in claim 4, wherein the constant current charging is about 0.2 C to about 0.4 C or the constant current charging is about 0.01 C to about 0.5 C.

8. A device (100) for evaluating an accelerated idle life of a secondary battery, comprising:
an input unit (110) receiving an idle temperature and a measurement period for a reference performance test evaluating the accelerated idle life of the secondary battery;
a data computation unit (121) computing an evaluation period, in which a state of health of the secondary battery reaches a predetermined range, a capacity degradation rate, and a direct current internal resistance change rate; and
an acceleration factor calculation unit (122) calculating an acceleration factor of the secondary battery using a first equation wherein the acceleration factor is equal to the direct current internal resistance change rate divided by a capacity degradation rate.

9. The device as claimed in claim 8, wherein, after the secondary battery is idled in a state in which a state of charge is about 100% at a first temperature, the reference performance test is performed at a second temperature less than the first temperature for every measurement period.

10. The device as claimed in claim9, wherein the first temperature is about 50°C to about 80°C, the second temperature is about 20°C to about 30°C, and the measurement period is about 10 days to about 40 days.

11. The device as claimed in claim 8, wherein the reference performance test is performed by charging the secondary battery in a constant current-constant voltage manner and discharging the secondary battery in a constant current manner.

12. The device as claimed in any one of claims 8 to 11, wherein the predetermined range of the state of health of the secondary battery is about 80% to about 90%.

13. The device as claimed in any one of claims 8 to 12, wherein the acceleration factor is about 4 to about 7.

## Patentansprüche

1. Verfahren zum Bewerten einer beschleunigten Leerlauflebensdauer einer Sekundärbatterie, umfassend:
einen Bewertungsbedingungseingabevorgang (S11), der Eingeben einer Leerlauftemperatur und eines Messzeitraums für einen Referenzleistungstest enthält, um die beschleunigte Leerlauflebensdauer der Sekundärbatterie zu bewerten;
einen Datenberechnungsvorgang (S12), der Berechnen eines Bewertungszeitraums, in dem ein Gesundheitszustand der Sekundärbatterie einen festgelegten Bereich erreicht, einer Kapazitätsverschlechterungsrate und einer Gleichstrominnenwiderstandsänderungsrate enthält, und
einen Beschleunigungsfaktorrechenvorgang (S13), der Errechnen eines Beschleunigungsfaktors der Sekundärbatterie unter Verwendung einer ersten Gleichung enthält, dass der Beschleunigungsfaktor gleich der Gleichstrominnenwiderstandsänderungsrate dividiert durch eine Kapazitätsverschlechterungsrate ist.

2. Verfahren nach Anspruch 1, wobei, nachdem die Sekundärbatterie im Leerlauf ist, während ein Ladezustand bei einer ersten Temperatur etwa 100 % beträgt, der Referenzleistungstest bei einer zweiten Temperatur, die niedriger als die erste Temperatur ist, für jeden Messzeitraum durchgeführt wird.

3. Verfahren nach Anspruch 2, wobei die erste Temperatur etwa 50 °C bis etwa 80 °C beträgt, die zweite Temperatur etwa 20 °C bis etwa 30 °C beträgt und der Messzeitraum etwa 10 Tage bis etwa 40 Tage beträgt.

4. Verfahren nach Anspruch 1, wobei der Referenzleistungstest durch Laden der Sekundärbatterie auf eine Art mit Konstantstrom-Konstantspannung und Entladen der Sekundärbatterie auf eine Art mit Konstantstrom durchgeführt wird.

5. Verfahren nach einem der vorhergehenden Ansprüche, wobei der festgelegte Bereich des Gesundheitszustands der Sekundärbatterie etwa 80 % bis etwa 90 % beträgt.

6. Verfahren nach einem der vorhergehenden Ansprüche, wobei der Beschleunigungsfaktor etwa 4 bis etwa 7 beträgt.

7. Verfahren nach Anspruch 4, wobei das Konstantstromladen etwa 0,2 C bis etwa 0,4 C beträgt oder das Konstantstromladen etwa 0,01 C bis etwa 0,5 C beträgt.

8. Vorrichtung (100) zum Bewerten einer beschleunigten Leerlauflebensdauer einer Sekundärbatterie, umfassend:
eine Eingabeeinheit (110), die eine Leerlauftemperatur und einen Messzeitraum für einen Referenzleistungstest empfängt, der die beschleunigte Leerlauflebensdauer der Sekundärbatterie bewertet;
eine Datenberechnungseinheit (121), die einen Bewertungszeitraum, in dem ein Gesundheitszustand der Sekundärbatterie einen vorbestimmten Bereich erreicht, eine Kapazitätsverschlechterungsrate und eine Gleichstrominnenwiderstandsänderungsrate berechnet; und
eine Beschleunigungsfaktorrecheneinheit (122), die einen Beschleunigungsfaktor der Sekundärbatterie unter Verwendung einer ersten Gleichung errechnet, wobei der Beschleunigungsfaktor gleich der Gleichstrominnenwiderstandsänderungsrate dividiert durch eine Kapazitätsverschlechterungsrate ist.

9. Vorrichtung nach Anspruch 8, wobei, nachdem die Sekundärbatterie in einem Zustand, in dem ein Ladezustand bei einer ersten Temperatur etwa 100 % beträgt, im Leerlauf ist, der Referenzleistungstest bei einer zweiten Temperatur, die niedriger als die erste Temperatur ist, für jeden Messzeitraum durchgeführt wird.

10. Vorrichtung nach Anspruch 9, wobei die erste Temperatur etwa 50 °C bis etwa 80 °C beträgt, die zweite Temperatur etwa 20 °C bis etwa 30 °C beträgt und der Messzeitraum etwa 10 Tage bis etwa 40 Tage beträgt.

11. Vorrichtung nach Anspruch 8, wobei der Referenzleistungstest durch Laden der Sekundärbatterie auf eine Art mit Konstantstrom-Konstantspannung und Entladen der Sekundärbatterie auf eine Art mit Konstantstrom durchgeführt wird.

12. Vorrichtung nach einem der Ansprüche 8 bis 11, wobei der vorbestimmte Bereich des Gesundheitszustands der Sekundärbatterie etwa 80 % bis etwa 90 % beträgt.

13. Vorrichtung nach einem der Ansprüche 8 bis 12, wobei der Beschleunigungsfaktor etwa 4 bis etwa 7 beträgt.

## Revendications

1. Procédé d'évaluation de durée de vie en veille accélérée d'une batterie secondaire, comprenant :
un processus d'entrée de condition d'évaluation (S11) comprenant l'entrée d'une température en veille et d'une période de mesure pour un test de performance de référence afin d'évaluer la durée de vie en veille accélérée de la batterie secondaire ;
un processus de calcul de données (S12) comprenant le calcul d'une période d'évaluation, dans laquelle un état de santé de la batterie secondaire atteint une plage définie, un taux de dégradation de capacité et un taux de changement de résistance interne en courant continu ; et
un processus de calcul de facteur d'accélération (S13) comprenant le calcul d'un facteur d'accélération de la batterie secondaire en utilisant une première équation selon laquelle le facteur d'accélération est égal au taux de changement de résistance interne en courant continu divisé par un taux de dégradation de capacité.

2. Procédé selon la revendication 1, dans lequel, une fois que la batterie secondaire est en veille alors qu'un état de charge est d'environ 100 % à une première température, le test de performance de référence est effectué à une deuxième température inférieure à la première température pour chaque période de mesure.

3. Procédé selon la revendication 2, dans lequel la première température est d'environ 50 °C à environ 80 °C, la deuxième température est d'environ 20 °C à environ 30 °C, et la période de mesure est d'environ 10 jours à environ 40 jours.

4. Procédé selon la revendication 1, dans lequel le test de performance de référence est effectué en chargeant la batterie secondaire selon un régime à tension constante et courant constant et en déchargeant la batterie secondaire selon un régime à courant constant.

5. Procédé selon l'une quelconque des revendications précédentes, dans lequel la plage définie de l'état de santé de la batterie secondaire est d'environ 80 % à environ 90 %.

6. Procédé selon l'une quelconque des revendications précédentes, dans lequel le facteur d'accélération est d'environ 4 à environ 7.

7. Procédé selon la revendication 4, dans lequel la charge à courant constant est d'environ 0,2 C à environ 0,4 C ou la charge à courant constant est d'environ 0,01 C à environ 0,5 C.

8. Dispositif (100) d'évaluation de durée de vie en veille accélérée d'une batterie secondaire, comprenant :
une unité d'entrée (110) recevant une température en veille et une période de mesure pour un test de performance de référence évaluant la durée de vie en veille accélérée de la batterie secondaire ;
une unité de calcul de données (121) calculant une période d'évaluation, dans laquelle un état de santé de la batterie secondaire atteint une plage prédéterminée, un taux de dégradation de capacité et un taux de changement de résistance interne en courant continu ; et
une unité de calcul de facteur d'accélération (122) calculant un facteur d'accélération de la batterie secondaire en utilisant une première équation dans laquelle le facteur d'accélération est égal au taux de changement de résistance interne en courant continu divisé par un taux de dégradation de capacité.

9. Dispositif selon la revendication 8, dans lequel, une fois que la batterie secondaire est en veille dans un état dans lequel un état de charge est d'environ 100 % à une première température, le test de performance de référence est effectué à une deuxième température inférieure à la première température pour chaque période de mesure.

10. Dispositif selon la revendication 9, dans lequel la première température est d'environ 50 °C à environ 80 °C, la deuxième température est d'environ 20 °C à environ 30 °C, et la période de mesure est d'environ 10 jours à environ 40 jours.

11. Dispositif selon la revendication 8, dans lequel le test de performance de référence est effectué en chargeant la batterie secondaire selon un régime à tension constante et courant constant et en déchargeant la batterie secondaire selon un régime à courant constant.

12. Dispositif selon l'une quelconque des revendications 8 à 11, dans lequel la plage prédéterminée de l'état de santé de la batterie secondaire est d'environ 80 % à environ 90 %.

13. Dispositif selon l'une quelconque des revendications 8 à 12, dans lequel le facteur d'accélération est d'environ 4 à environ 7.
